# EUROPEAN PATENT SPECIFICATION

(11) **EP 2 728 038 B1**
(45) Date of publication and mention of the grant of the patent: **02.11.2016**
(21) Application number: 12852962.5
(22) Date of filing: 15.11.2012
(51) Int. Cl.: C23C 14/34, H01L 21/28, H01L 21/285, C23C 14/06, C01B 21/06, C23C 14/18

(54) **TANTALUM SPUTTERING TARGET AND METHOD FOR MANUFACTURING SAME**
TANTAL-SPUTTERTARGET UND HERSTELLUNGSVERFAHREN DAFÜR
CIBLE DE PULVÉRISATION DE TANTALE ET PROCÉDÉ POUR SA FABRICATION

(30) Priority: 30.11.2011 JP 2011261550
(43) Date of publication of application: 07.05.2014
(73) Proprietor: JX Nippon Mining & Metals Corporation, Tokyo 100-8164 (JP)
(72) Inventor: SENDA Shinichiro, Kitaibaraki-shi Ibaraki 319-1535 (JP); NAGATSU Kotaro, Kitaibaraki-shi Ibaraki 319-1535 (JP)
(74) Representative: Hoarton, Lloyd Douglas Charles
(86) International application number: PCT/JP2012/079598
(87) International publication number: WO 2013/080801

(56) References cited:
- WO-A1-03/025238
- WO-A1-2009/107763
- WO-A2-2006/086319
- JP-A- 2005 336 617
- JP-A- 2007 530 789
- JP-A- 2009 108 412
- US-A1- 2005 247 386
- JIANG A ET AL: "Investigation of the structure of beta-tantalum", THIN SOLID FILMS, ELSEVIER-SEQUOIA S.A. LAUSANNE, CH, vol. 437, no. 1-2, 1 August 2003 (2003-08-01), pages 116-122, XP004438583, ISSN: 0040-6090, DOI: 10.1016/S0040-6090(03)00702-8

## Description

### TECHNICAL FIELD

The present invention relates to a tantalum sputtering target and a method for manufacturing the target. In particular, the invention relates to a tantalum sputtering target that is used for forming a Ta film or a TaN film as a diffusion barrier layer for copper wiring in an LSI and relates to a method for manufacturing the target.

### BACKGROUND ART

Conventionally, aluminum was used as a wiring material of semiconductor elements. However, a problem of wiring delay began to occur with progress in miniaturization and integration of elements, and copper, which has a lower electric resistance, has been put into use instead of aluminum. Copper is very effective as a wiring material, but copper itself is an active metal and therefore has a problem of diffusing into and contaminating an interlayer insulating film. Accordingly, it is necessary to dispose a diffusion barrier layer such as a Ta film or a TaN film between the copper wiring and the interlayer insulating film.

In general, a Ta film or a TaN film is formed by sputtering a tantalum target. In tantalum targets, it is hitherto known that various impurities contained in the targets, gas compositions, crystal plane direction, crystal grain diameter, and other factors affect the sputtering performance, such as the film-forming rate, the uniformity of film thickness, and particle generation.

For example, Patent Document 1 describes an improvement in the film uniformity by a crystal structure in which the orientation (222) is preferential from a position in 30% of the target thickness toward the central plane of the target. Patent Document 2 describes an increase in film-forming rate and an improvement in the film uniformity by random crystalline orientation of a tantalum target (crystals are not aligned in a specific direction). Patent Document 3 describes that the uniformity is improved through an increase in film-forming rate and a decrease in the variation of plane direction by selectively increasing the plane directions (110), (200), and (211) in which atomic densities are high.

Furthermore, Patent Document 4 describes that the uniformity in film thickness is improved by decreasing the variation in intensity ratio of plane (110) determined by X-ray diffraction depending on the region of sputtering surface portion within 20%. Patent Document 5 describes that a circular metal target having a very strong crystallographic texture such as (111) and (100) can be produced by employing swaging, extrusion, rotary forging, or unlubricating upset-forging in combination with clock rolling. Unfortunately, the sputtering using these tantalum targets has a problem that the sputter rate (film-forming rate) is not always high, resulting in a low throughput.

In addition, Patent Document 6 describes a method for manufacturing a tantalum sputtering target by subjecting a tantalum ingot to forging, annealing, and rolling and performing a final composition processing and then annealing at a temperature of 1173 K or less to control the amount of unrecrystallized structure to be 20% or less and 90% or less. In this case, however, there is no idea to increase the sputter rate for improving the throughput by controlling the crystalline orientation.

In addition, Patent Document 7 discloses a process of stabilizing sputtering characteristics by controlling the relative strengths of peaks of the sputtering surface of a target to be (110) > (211) > (200) through processes, such as forging and cold-rolling, and heat treatment. In this case, however, there is no idea to increase the sputter rate for improving the throughput by controlling the crystalline orientation.

Furthermore, in Patent Document 8, a tantalum ingot is subjected to a forging process in which heat treatment is performed at least two times and is further subjected to cold rolling and then recrystallization heat treatment. In also this case, however, there is no idea to increase the sputter rate for improving the throughput by controlling the crystalline orientation.

Patent Document 1: Japanese Patent Laid-Open No. 2004-107758
Patent Document 2: International Publication No. WO2005/045090
Patent Document 3: Japanese Patent Laid-Open No. H11-80942
Patent Document 4: Japanese Patent Laid-Open No. 2002-363736
Patent Document 5: National Publication No. 2008-532765 of International Patent Application
Patent Document 6: Japanese Patent No. 4754617
Patent Document 7: International Publication No. WO2011/061897
Patent Document 8: Japanese Patent No. 4714123

WO 03/025238 discloses a sputter target including a tantalum body having tantalum grains formed from consolidating tantalum powder and a sputter face. The tantalum grains have at least a 40% (222) direction orientation ratio and less than 15% (110) direction ratio in an atom transport direction away from the sputter face for increasing sputtering uniformity.

WO 2006/086319 discloses a process for processing metal which includes clock rolling a metal plate until the desired thickness is achieved to form a rolled plate. Sputtering targets and other metal articles are further described.

### SUMMARY OF INVENTION

### [Technical Problem]

It is an object of the present invention to increase the sputter rate by controlling the crystalline orientation of the sputtering surface of a tantalum sputtering target and thereby to form a film having an intended thickness in a short time, resulting in an increase in throughput. In particular, it is an object of the invention to provide a tantalum sputtering target useful for forming a diffusion barrier layer such as a Ta film or a TaN film that can effectively prevent contamination of the periphery of wiring due to diffusion of active Cu.

### [Solution to Problem]

In order to solve the above-mentioned problems, the present invention provides a tantalum sputtering target and a method for manufacturing the target as claimed.

### [Advantageous Effects of Invention]

The tantalum sputtering target of the present invention shows a high sputter rate due to the controlled crystalline orientation of the sputtering surface of the target and thereby has an excellent effect capable of forming a film having an intended thickness in a short time to increase the throughput. In particular, the tantalum sputtering target shows an excellent effect in formation of a diffusion barrier layer such as a Ta film or a TaN film that can effectively prevent contamination of the periphery of wiring due to diffusion of active copper.

### BRIEF DESCRIPTION OF DRAWING

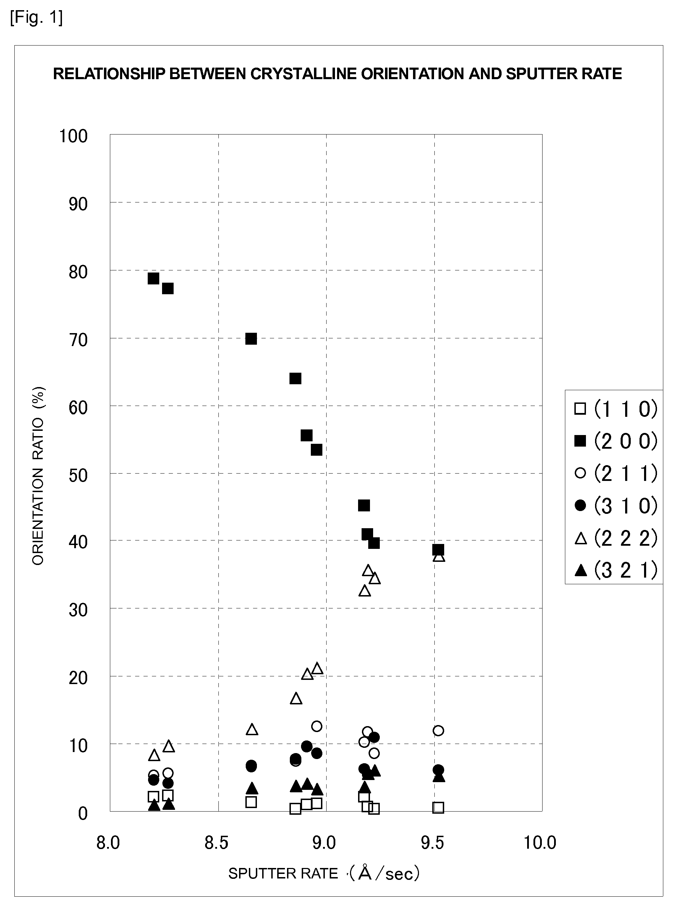

[Figure 1] This is a graph showing a relationship between crystalline orientation and sputter rate in Examples and Comparative Examples of the present invention.

### DESCRIPTION OF EMBODIMENTS

The tantalum sputtering target of the present invention is characterized by a decreased (200)-plane orientation ratio and an increased (222)-plane orientation ratio of the sputtering surface of the target.

The crystal structure of tantalum is a body-centered cubic lattice structure (abbreviated to BCC). Consequently, the distance between adjacent atoms in the (222)-plane is shorter than that in the (200)-plane, and therefore the atoms in the (222)-plane is in a state being more densely packed compared to those in the (200)-plane. Accordingly, it is believed that the (222)-plane emits a larger number of tantalum atoms than the (200)-plane does during sputtering to increase the sputter rate (film-forming rate).

In the present invention, the tantalum sputtering target preferably has a (200)-plane orientation ratio of 70% or less and a (222)-plane orientation ratio of 10% or more at the sputtering surface of the target. More preferably, the (200)-plane orientation ratio is 60% or less and the (222)-plane orientation ratio is 20% or more. Most preferably, the (200)-plane orientation ratio is 60% or less and the (222)-plane orientation ratio is 20% or more.

In order to provide a stable crystal structure, it is preferable that the (200)-plane orientation ratio be 50% or more and the (222)-plane orientation ratio be 30% or less. The lower limit of the (200)-plane orientation ratio is desirably 30%, and the upper limit of the (222)-plane orientation ratio is desirably 40%. The lower limit of the (200)-plane orientation ratio and the upper limit of the (222)-plane orientation ratio are not particularly limited, but a (200)-plane orientation ratio of lower than 30% or a (222)-plane orientation ratio of higher than 40% causes a sputter rate exceeding 10 A/sec, which is too short for forming a uniform barrier film in the case of a tantalum barrier thin film. However, as necessary, a (200)-plane orientation ratio lower than the lower limit of 30% or a (222)-plane orientation ratio higher than the upper limit of 40% can be employed.

The orientation ratio in the present invention means the ratio of the intensity in a specific plane direction when standardizing the measurement intensities of the respective diffraction peaks of planes (110), (200), (211), (310), (222), and (321) measured by X-ray diffraction analysis and defining the sum of the intensities in the respective plane directions as 100. The standardization was performed with JCPDS (Joint Committee for Powder Diffraction Standard).

For example, the (200)-plane orientation ratio (%) is calculated by {[measurement intensity of (200)/JCPDS intensity of (200)]/∑(measurement intensity of each plane/JCPDS intensity of each plane)}×100.

The tantalum sputtering target of the present invention can be used for forming a diffusion barrier layer such as a Ta film or a TaN film in copper wiring. Even in a case of forming a TaN film by introducing nitrogen into the atmosphere during sputtering, the sputtering target of the present invention can increase the sputter rate compared to conventional sputtering targets. The sputtering efficiency can be thus improved to allow formation of a film having an intended thickness in a shorter time than ever before and significant increases in the throughput of forming copper wiring having the diffusion barrier layer such as the Ta film or the TaN film and further in the throughput of producing a semiconductor device having the copper wiring.

The tantalum sputtering target of the present invention is produced by a process shown below for example. Tantalum having a high purity of 4N (99.99%) or more is usually used as a tantalum raw material. The tantalum raw material is molten by, for example, electron beam melting. The molten tantalum is cast into an ingot or billet. Subsequently, the ingot or billet is subjected to forging and recrystallization annealing. Specifically, for example, an ingot or billet is subjected to press forging, annealing at a temperature of 1100°C to 1400°C, cold forging (primary forging), annealing at a temperature of recrystallization temperature to 1400°C, cold forging (secondary forging), and annealing at a temperature of recrystallization temperature to 1400°C in this order.

Subsequently, cold rolling is performed. The orientation ratio of the tantalum sputtering target of the present invention can be controlled by adjusting the conditions for the cold rolling. Specifically, a rolling roll having a larger roll diameter, such as a diameter of 500 mm or more, is preferred. A higher rolling speed, such as a rolling speed of 10 m/min or more, is preferred. Furthermore, in a case of performing the rolling only once, a high rolling ratio exceeding 80% is preferred. In a case of performing the rolling at least twice, it is necessary to control the final thickness of the target to be the same as that in the case of performing the rolling only once by controlling the rolling ratio to be 60% or more.

Subsequently, heat treatment is performed. The orientation ratio of the tantalum sputtering target of the present invention can be controlled through the cold rolling and the heat treatment by adjusting the conditions for the heat treatment after the cold rolling. Specifically, a higher temperature of the heat treatment, such as a temperature of 900°C to 1400°C, is preferred. Though it varies depending on the amount of strain introduced during rolling, the heat treatment needs a temperature of 900°C or more for providing a recrystallized structure, while heat treatment at a temperature higher than 1400°C is economically undesirable. Then, the surface of the target is subjected to finish processing such as mechanical processing or polishing processing to give a final product.

The tantalum target is produced through the process described above, and it is particularly important in the present invention that the crystalline orientation of the sputtering surface of the target has a low (200)-plane orientation ratio and a high (222)-plane orientation ratio.

The orientation is mainly controlled in the rolling step. The amount and distribution of strain to be introduced during rolling can be varied by controlling the parameters in the rolling, such as the diameter of rolling roll, the rolling speed, and rolling ratio, and thereby the (200)-plane orientation ratio and the (222)-plane orientation ratio can be controlled.

In order to effectively adjust the plane orientation ratios, modulation of conditions needs to be repeated to some extent. However, when a condition for providing proper (200)-plane orientation ratio and (222)-plane orientation ratio has been determined once, targets having constant characteristics (having a certain level of characteristics) can be produced under the determined condition.

Usually, a target is effectively produced using a rolling roll having a diameter of 500 mm or more at a rolling speed of 10 m/min or more and a rolling ratio of 8% to 12% in one pass, but the production process is not limited to this, and any production process that can achieve the crystalline orientation of the present invention can be employed. In a series of the processes, conditions for destroying the cast structure by forging and rolling and also sufficiently performing recrystallization are effective.

Furthermore, the tantalum ingot or billet subjected to processes such as molting, casting, forging, and rolling is desirably subjected to recrystallization annealing to give fine and uniform structure.

### [Examples]

The present invention will now be described by Examples. The following Examples are intended to facilitate understanding and do not limit the present invention. That is, modifications and other examples based on the technical idea of the present invention are included in the invention.

A tantalum raw material having a purity of 99.995% was molten with electron beams, and the molten tantalum was cast into an ingot having a diameter of 195 mm. Subsequently, the ingot was press-forged at room temperature into a diameter of 150 mm, followed by recrystallization annealing at a temperature of 1100°C to 1400°C. The ingot was forged (primary forging) at room temperature again into a thickness of 100 mm and a diameter of 150 mm, followed by recrystallization annealing at a temperature of recrystallization temperature to 1400°C. Furthermore, forging (secondary forging) at room temperature was performed to give a thickness of 70 to 100 mm and a diameter of 150 to 185 mm, and then recrystallization annealing at a temperature of recrystallization temperature to 1400°C was performed to give a target raw material.

### (Example 1)

In Example 1, the resulting target raw material was cold rolled with a rolling roll having a diameter of 650 mm at a rolling speed of 20 m/min and a rolling ratio of 92% into a thickness of 8 mm and a diameter of 520 mm, followed by heat treatment at 1000°C. Subsequently, the surface was cut and polished to give a target. As a result, a tantalum sputtering target having a crystal structure having a (200)-plane orientation ratio of 38.6% and a (222)-plane orientation ratio of 37.8% was obtained. Sputtering using this sputtering target gave a satisfactory sputter rate of 9.52 A/sec to improve the sputtering efficiency. The results are shown in Table 1.

The sputtering conditions were as follows:
Power source: direct current system
Power: 15 kW
Ultimate vacuum: 5×10⁻⁸ Torr
Atmospheric gas composition: Ar
Sputtering gas pressure: 5×10⁻³ Torr
Sputtering time: 15 seconds

### (Example 2)

In Example 2, the resulting target raw material was cold rolled with a rolling roll having a diameter of 650 mm at a rolling speed of 20 m/min and a rolling ratio of 66% into a thickness of 24 mm and a diameter of 300 mm, followed by heat treatment at 1100°C. This target material was cold rolled again at a rolling ratio of 67% into a thickness of 8 mm and a diameter of 520 mm, followed by heat treatment at 900°C. Subsequently, the surface was cut and polished to give a target. As a result, a tantalum sputtering target having a crystal structure having a (200)-plane orientation ratio of 39.6% and a (222)-plane orientation ratio of 34.5% was obtained. Sputtering using this sputtering target gave a satisfactory sputter rate of 9.23 A/sec to improve the sputtering efficiency. The results are shown in Table 1.

### (Example 3)

In Example 3, the resulting target raw material was cold rolled with a rolling roll having a diameter of 500 mm at a rolling speed of 20 m/min and a rolling ratio of 91% into a thickness of 8 mm and a diameter of 520 mm, followed by heat treatment at 1000°C. Subsequently, the surface was cut and polished to give a target. As a result, a tantalum sputtering target having a crystal structure having a (200)-plane orientation ratio of 40.8% and a (222)-plane orientation ratio of 35.7% was obtained. Sputtering using this sputtering target gave a satisfactory sputter rate of 9.19 A/sec to improve the sputtering efficiency. The results are shown in Table 1.

### (Example 4)

In Example 4, the resulting target raw material was cold rolled with a rolling roll having a diameter of 650 mm at a rolling speed of 15 m/min and a rolling ratio of 65% into a thickness of 24 mm and a diameter of 300 mm, followed by heat treatment at 1100°C. This target material was cold rolled again at a rolling ratio of 67% into a thickness of 8 mm and a diameter of 520 mm, followed by heat treatment at 900°C. Subsequently, the surface was cut and polished to give a target. As a result, a tantalum sputtering target having a crystal structure having a (200)-plane orientation ratio of 45.2% and a (222)-plane orientation ratio of 32.7% was obtained. Sputtering using this sputtering target gave a satisfactory sputter rate of 9.18 A/sec to improve the sputtering efficiency. The results are shown in Table 1.

### (Example 5)

In Example 5, the resulting target raw material was cold rolled with a rolling roll having a diameter of 650 mm at a rolling speed of 15 m/min and a rolling ratio of 90% into a thickness of 8 mm and a diameter of 520 mm, followed by heat treatment at 1200°C. Subsequently, the surface was cut and polished to give a target. As a result, a tantalum sputtering target having a crystal structure having a (200)-plane orientation ratio of 53.4% and a (222)-plane orientation ratio of 21.2% was obtained. Sputtering using this sputtering target gave a satisfactory sputter rate of 8.96 A/sec to improve the sputtering efficiency. The results are shown in Table 1.

### (Example 6)

In Example 6, the resulting target raw material was cold rolled with a rolling roll having a diameter of 500 mm at a rolling speed of 20 m/min and a rolling ratio of 92% into a thickness of 8 mm and a diameter of 520 mm, followed by heat treatment at 900°C. Subsequently, the surface was cut and polished to give a target. As a result, a tantalum sputtering target having a crystal structure having a (200)-plane orientation ratio of 55.4% and a (222)-plane orientation ratio of 20.4% was obtained. Sputtering using this sputtering target gave a satisfactory sputter rate of 8.91 A/sec to improve the sputtering efficiency. The results are shown in Table 1.

### (Example 7)

In Example 7, the resulting target raw material was cold rolled with a rolling roll having a diameter of 500 mm at a rolling speed of 10 m/min and a rolling ratio of 90% into a thickness of 8 mm and a diameter of 520 mm, followed by heat treatment at 1400°C. Subsequently, the surface was cut and polished to give a target. As a result, a tantalum sputtering target having a crystal structure having a (200)-plane orientation ratio of 63.9% and a (222)-plane orientation ratio of 16.8% was obtained. Sputtering using this sputtering target gave a satisfactory sputter rate of 8.86 A/sec to improve the sputtering efficiency. The results are shown in Table 1.

### (Example 8)

In Example 8, the resulting target raw material was cold rolled with a rolling roll having a diameter of 500 mm at a rolling speed of 20 m/min and a rolling ratio of 82% into a thickness of 8 mm and a diameter of 520 mm, followed by heat treatment at 900°C. Subsequently, the surface was cut and polished to give a target. As a result, a tantalum sputtering target having a crystal structure having a (200)-plane orientation ratio of 69.8% and a (222)-plane orientation ratio of 12.1 % was obtained. Sputtering using this sputtering target gave a satisfactory sputter rate of 8.66 A/sec to improve the sputtering efficiency. The results are shown in Table 1.

### (Comparative Example 1)

In Comparative Example 1, the resulting target raw material was cold rolled with a rolling roll having a diameter of 650 mm at a rolling speed of 20 m/min and a rolling ratio of 80% into a thickness of 8 mm and a diameter of 520 mm, followed by heat treatment at 800°C. Subsequently, the surface was cut and polished to give a target. As a result, a tantalum sputtering target having a crystal structure having a (200)-plane orientation ratio of 77.2% and a (222)-plane orientation ratio of 9.6% was obtained. Sputtering using this sputtering target gave a low sputter rate of 8.27 A/sec to cause a decrease in throughput. The results are also shown in Table 1.

### (Comparative Example 2)

In Comparative Example 2, the resulting target raw material was cold rolled with a rolling roll having a diameter of 500 mm at a rolling speed of 15 m/min and a rolling ratio of 80% into a thickness of 8 mm and a diameter of 520 mm, followed by heat treatment at 800°C. Subsequently, the surface was cut and polished to give a target. As a result, a tantalum sputtering target having a crystal structure having a (200)-plane orientation ratio of 78.7% and a (222)-plane orientation ratio of 8.3% was obtained. Sputtering using this sputtering target gave a low sputter rate of 8.21 A/sec to cause a decrease in throughput. The results are also shown in Table 1.

### (Comparative Example 3)

In Comparative Example 3, the resulting target raw material was cold rolled with a rolling roll having a diameter of 400 mm at a rolling speed of 10 m/min and a rolling ratio of 78% into a thickness of 8 mm and a diameter of 520 mm, followed by heat treatment at 1100°C. Subsequently, the surface was cut and polished to give a target. As a result, a tantalum sputtering target having a crystal structure having a (200)-plane orientation ratio of 85.3% and a (222)-plane orientation ratio of 8.0% was obtained. Sputtering using this sputtering target gave a low sputter rate of 8.05 Å/sec to cause a decrease in throughput. The results are also shown in Table 1.

### (Comparative Example 4)

In Comparative Example 4, the resulting target raw material was cold rolled with a rolling roll having a diameter of 400 mm at a rolling speed of 10 m/min and a rolling ratio of 75% into a thickness of 8 mm and a diameter of 520 mm, followed by heat treatment at 1200°C. Subsequently, the surface was cut and polished to give a target. As a result, a tantalum sputtering target having a crystal structure having a (200)-plane orientation ratio of 87.5% and a (222)-plane orientation ratio of 6.8% was obtained. Sputtering using this sputtering target gave a low sputter rate of 7.83 Å/sec to cause a decrease in throughput. The results are also shown in Table 1.

As shown in Examples and Comparative Examples, the targets satisfying the conditions of the present invention show high sputter rates to improve the throughput. The relationship between crystalline orientation and sputter rate in Examples and Comparative Examples is shown in Fig. 1. As shown in Fig. 1, it is revealed that the sputter rate increases with a decrease in (200)-plane orientation ratio or an increase in (222)-plane orientation ratio.

**[Table 1]**

| | Rolling roll diameter | Rolling speed | Rolling ratio in one pass | First time | | Second time | | (200) Orientation ratio | (222) Orientation ratio | Ta Sputtering rate | Determination |
|---|---|---|---|---|---|---|---|---|---|---|---|
| | (mm) | (m/min) | (%) | Rolling ratio | Heat treatment temperature | Rolling ratio | Heat treatment temperature | (%) | (%) | (Å/sec) | |
| Example 1 | 650 | 20 | 10∼12 | 92% | 1000°C | | | 38.6 | 37.8 | 9.52 | ⊚ |
| Example 2 | 650 | 20 | 8∼10 | 66% | 1100°C | 67% | 900°C | 39.6 | 34.5 | 9.23 | ⊚ |
| Example 3 | 500 | 20 | 10∼12 | 91% | 1000°C | | | 40.8 | 35.7 | 9.19 | ⊚ |
| Example 4 | 650 | 15 | 10∼12 | 65% | 1100°C | 67% | 900°C | 45.2 | 32.7 | 9.18 | ⊚ |
| Example 5 | 650 | 15 | 8∼10 | 90% | 1200°C | | | 53.4 | 21.2 | 8.96 | ○ |
| Example 6 | 500 | 20 | 8∼10 | 92% | 900°C | | | 55.4 | 20.4 | 8.91 | ○ |
| Example 7 | 500 | 10 | 10∼12 | 90% | 1400°C | | | 63.9 | 16.8 | 8.86 | ○ |
| Example 8 | 500 | 20 | 10∼12 | 82% | 900°C | | | 69.8 | 12.1 | 8.66 | ○ |
| Comparative Example 1 | 650 | 20 | 8∼10 | 80% | 800°C | | | 77.2 | 9.6 | 8.27 | × |
| Comparative Example 2 | 500 | 15 | 8∼10 | 80% | 800°C | | | 78.7 | 8.3 | 8.21 | × |
| Comparative Example 3 | 400 | 10 | 10∼12 | 78% | 1100°C | | | 85.3 | 8.0 | 8.05 | × |
| Comparative Example 4 | 400 | 10 | 8∼10 | 75% | 1200°C | | | 87.5 | 6.8 | 7.83 | × |

| | | | | | | | | | | | |
|---|---|---|---|---|---|---|---|---|---|---|---|
| Determination: ⊚ : a sputter rate of 9.0 Å/sec or more ○: a sputter rate of 8.5 Å/sec or more × : a sputter rate of less than 8.5 Å/sec | | | | | | | | | | | |

### INDUSTRIAL APPLICABILITY

The present invention provides a tantalum sputtering target that shows a high sputter rate due to the controlled crystalline orientation of the sputtering surface of the target and thereby has an excellent effect capable of forming a film having an intended thickness in a short time to increase the throughput.

The tantalum sputtering target of the present invention is particularly useful for forming a diffusion barrier layer such as a Ta film or a TaN film that can effectively prevent contamination of the periphery of wiring due to diffusion of active Cu.

## Claims

1. A tantalum sputtering target having a (200)-plane orientation ratio of ≥ 30% and ≤70% and a (222)-plane orientation ratio of 10% or more at the sputtering surface of the tantalum sputtering target.

2. The tantalum sputtering target according to claim 1, having a (200)-plane orientation ratio of 60% or less and a (222)-plane orientation ratio of 20% or more at the sputtering surface of the tantalum sputtering target.

3. The tantalum sputtering target according to claim 1, having a (200)-plane orientation ratio of 50% or less and a (222)-plane orientation ratio of 30% or more at the sputtering surface of the tantalum sputtering target.

4. A method for manufacturing a tantalum sputtering target, the method comprising:
forging and recrystallization annealing a tantalum ingot obtained through melting and casting at a temperature of 1100 to 1400°C;
cold rolling using a rolling roll having a diameter of 500 mm or more at a rolling speed of 10 m/min or more; and
heat-treating the annealed ingot at a temperature of 900°C to 1400°C to form a crystal structure having a (200)-plane orientation ratio of ≥ 30% and ≤70% and a (222)-plane orientation ratio of 10% or more at the sputtering surface of the target.

5. The method for manufacturing a tantalum sputtering target according to claim 4, wherein the rolling ratio in one pass is 8 to 12%.

6. The method for manufacturing a tantalum sputtering target according to claim 4 or 5, wherein the forging and recrystallization annealing are performed at least twice.

7. The method for manufacturing a tantalum sputtering target according to any one of claims 4 to 6, wherein the rolling ratio exceeds 80%.

8. The method for manufacturing a tantalum sputtering target according to any one of claims 4 to 6, wherein the rolling ratio is 60% or more.

9. The method for manufacturing a tantalum sputtering target according to any one of claims 4 to 8, further comprising:
surface finishing by cutting and polishing after the rolling and heat treatment.

## Patentansprüche

1. Tantal-Sputtertarget, aufweisend ein Orientierungsverhältnis in der (200)-Ebene von ≥ 30 % und ≤ 70 % und ein Orientierungsverhältnis in der (222)-Ebene von 10 % oder mehr an der Sputteroberfläche des Tantal-Sputtertargets.

2. Tantal-Sputtertarget nach Anspruch 1, aufweisend ein Orientierungsverhältnis in der (200)-Ebene von 60 % oder weniger und ein Orientierungsverhältnis in der (222)-Ebene von 20 % oder mehr an der Sputteroberfläche des Tantal-Sputtertargets.

3. Tantal-Sputtertarget nach Anspruch 1, aufweisend ein Orientierungsverhältnis in der (200)-Ebene von 50 % oder weniger und ein Orientierungsverhältnis in der (222)-Ebene von 30 % oder mehr an der Sputteroberfläche des Tantal-Sputtertargets.

4. Verfahren zur Herstellung eines Tantal-Sputtertargets, wobei das Verfahren Folgendes umfasst:
Schmieden und Rekristallisationsglühen eines Tantal-Ingots, der durch Schmelzen und Gießen bei einer Temperatur von 1100 bis 1400 °C gewonnen wird;
Kaltwalzen mithilfe einer Walzwerkswalze aufweisend einen Durchmesser von 500 mm oder mehr bei einer Walzgeschwindigkeit von 10 m/min oder mehr; und
Wärmebehandlung des geglühten Ingots bei einer Temperatur von 900 °C bis 1400 °C, um eine Kristallstruktur aufweisend ein Orientierungsverhältnis in der (200)-Ebene von ≥ 30 % und ≤ 70 % und ein Orientierungsverhältnis in der (222)-Ebene von 10 % oder mehr an der Sputteroberfläche des Targets zu bilden.

5. Verfahren zur Herstellung eines Tantal-Sputtertargets nach Anspruch 4, worin das Walzverhältnis in einem Durchgang 8 bis 12 % beträgt.

6. Verfahren zur Herstellung eines Tantal-Sputtertargets nach Anspruch 4 oder 5, worin das Schmieden und Rekristallisationsglühen mindestens zweimal durchgeführt werden.

7. Verfahren zur Herstellung eines Tantal-Sputtertargets nach irgendeinem der Ansprüche 4 bis 6, worin das Walzverhältnis 80 % überschreitet.

8. Verfahren zur Herstellung eines Tantal-Sputtertargets nach irgendeinem der Ansprüche 4 bis 6, worin das Walzverhältnis 60 % oder mehr beträgt.

9. Verfahren zur Herstellung eines Tantal-Sputtertargets nach irgendeinem der Ansprüche 4 bis 8, ferner umfassend:
Oberflächenbehandlung durch Zerspanen und Polieren nach der Walz- und Wärmebehandlung.

## Revendications

1. Cible de pulvérisation de tantale ayant un taux d'orientation du plan (200) supérieur ou égal à 30 % et inférieur ou égal à 70 %, et un taux d'orientation du plan (222) d'au moins 10 % au niveau de la surface de pulvérisation de la cible de pulvérisation de tantale.

2. Cible de pulvérisation de tantale selon la revendication 1, ayant un taux d'orientation du plan (200) inférieur ou égal à 60 %, et un taux d'orientation du plan (222) d'au moins 20 % au niveau de la surface de pulvérisation de la cible de pulvérisation de tantale.

3. Cible de pulvérisation de tantale selon la revendication 1, ayant un taux d'orientation du plan (200) inférieur ou égal à 50 %, et un taux d'orientation du plan (222) d'au moins 30 % au niveau de la surface de pulvérisation de la cible de pulvérisation de tantale.

4. Procédé de fabrication d'une cible de pulvérisation de tantale, le procédé consistant à :
forger un lingot de tantale et le soumettre à un recuit de recristallisation, ledit lingot étant obtenu par fusion et coulée à une température de 1100 à 1400 °C ;
laminer à froid au moyen d'un rouleau de laminage ayant un diamètre d'au moins 500 mm à une vitesse de laminage d'au moins 10 m/min ; et/ou
traiter à chaud le lingot recuit à une température de 900 °C à 1400 °C pour former une structure cristalline ayant un taux d'orientation du plan (200) supérieur ou égal à 30 % et inférieur ou égal à 70 %, et un taux d'orientation du plan (222) d'au moins 10 % au niveau de la surface de pulvérisation de la cible.

5. Procédé de fabrication d'une cible de pulvérisation de tantale selon la revendication 4, dans lequel le taux de laminage en une passe est de 8 à 12 %.

6. Procédé de fabrication d'une cible de pulvérisation de tantale selon la revendication 4 ou 5, dans lequel le forgeage et le recuit de recristallisation sont effectués au moins deux fois.

7. Procédé de fabrication d'une cible de pulvérisation de tantale selon l'une quelconque des revendications 4 à 6, dans lequel le taux de laminage est supérieur à 80 %.

8. Procédé de fabrication d'une cible de pulvérisation de tantale selon l'une quelconque des revendications 4 à 6, dans lequel le taux de laminage est supérieur ou égal à 60 %.

9. Procédé de fabrication d'une cible de pulvérisation de tantale selon l'une quelconque des revendications 4 à 8, consistant en outre à :
effectuer une finition de surface par taille et polissage après le laminage et le traitement thermique.
